(19) Europäisches Patentamt
European Patent Office
Office européen des brevets

(11) Veröffentlichungsnummer : **0 143 437**
**B1**

(12) # EUROPÄISCHE PATENTSCHRIFT

(45) Veröffentlichungstag der Patentschrift : **27.07.88**

(51) Int. Cl.⁴ : **G 03 F 7/10**

(21) Anmeldenummer : **84114104.7**

(22) Anmeldetag : **22.11.84**

(54) **Verfahren zur Herstellung von Resistmustern und für dieses Verfahren geeigneter Trockenresist.**

(30) Priorität : **26.11.83 DE 3342829**
**23.12.83 DE 3346716**

(43) Veröffentlichungstag der Anmeldung : **05.06.85 Patentblatt 85/23**

(45) Bekanntmachung des Hinweises auf die Patenterteilung : **27.07.88 Patentblatt 88/30**

(84) Benannte Vertragsstaaten : **CH DE FR GB IT LI NL**

(56) Entgegenhaltungen :
**DE-A- 1 949 208**
**US-A- 4 220 747**
**US-A- 4 262 073**

(73) Patentinhaber : **BASF Aktiengesellschaft**
**Carl-Bosch-Strasse 38**
**D-6700 Ludwigshafen (DE)**

(72) Erfinder : **Leyrer, Reinhold J., Dr.**
**Menzelstrasse 4**
**D-6700 Ludwigshafen (DE)**
Erfinder : **Wegner, Gerhard, Prof. Dr.**
**Hinterhofstrasse 46**
**D-7809 Denzlingen (DE)**
Erfinder : **Mueller, Michael**
**Burgstrasse 2**
**D-7808 Waldkirch (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 143 437 B1

Jouve, 18, rue St-Denis, 75001 Paris, France

**Beschreibung**

Die Erfindung betrifft einen Trockenfilmresist mit einer auf einem temporären, abziehbaren oder ablösbaren Träger aufgebrachten festen, strahlungsempfindlichen, positiv arbeitenden und unter Anwendung von Druck sowie gegebenenfalls Wärme auf ein Substrat übertragbaren Resistschicht und ein Verfahren zur Herstellung von bildmäßig strukturierten Resistmustern auf einem Substrat, bei dem eine auf das Substrat aufgebrachte, strahlungsempfindliche Resistschicht auf Basis eines abbaubaren Polymeren bildmäßig mit aktinischer Strahlung bestrahlt, hierbei das Polymere abgebaut und dadurch eine Eigenschaftsdifferenzierung zwischen den bestrahlten und unbestrahlten Bereichen der Resistschicht erzielt wird, die bestrahlten Bereiche der Resistschicht entfernt werden und anschließend das so erhaltene Resistmuster gegebenenfalls nachbehandelt wird.

Positiv arbeitende, lichtempfindliche Aufzeichnungsmaterialien für die Herstellung von bildmäßig strukturierten Resistmustern, wie sie beispielsweise bei der Herstellung von Leiterbahnen, gedruckten Schaltungen, Dünnschicht- und Mehrschichtschaltungen, elektronischen Bauelementen, in der Halbleitertechnik zur Anwendung kommen können, sind in der Literatur mehrfach beschrieben. Solche positiv arbeitenden Resistmaterialien sing beispielsweise auf Basis von o-Chinondiazid-Gruppen enthaltenden Verbindungen, insbesondere o-Chinondiazid-Gruppen enthaltenden Polymeren, aufgebaut, die bei Bestrahlung mit aktinischem Licht unter Bildung von alkalilöslichen Photolyseprodukten reagieren (vgl. z. B. DE-A-20 28 903, DE-A-22 36 914, US-A-3 782 939, US-A-3 837 860 und US-A-4 193 797). Eine andere Klasse von sehr vorteilhaften positiv arbeitenden, photoabbaubaren Resistmaterialien basiert auf aromatische und/oder heteroaromatische o-Nitrocarbinolestergruppierungen enthaltenden Polymeren, die nach der Belichtung mit wäßrig-alkalischen Entwicklerlösungsmitteln ausgewaschen werden können (vgl. z. B. DE-A-21 50 691 sowie DE-A-29 22 746).

Die bekannten positiv arbeitenden, photoabbaubaren Resistmaterialien und Trockenfilmresiste sind im Hinblick auf die modernen Anwendungen und hohen Anforderungen immer weiter verbesserungsbedürftig. So sind beispielsweise zum Teil die mechanische und chemische Beständigkeit dieser Resistmaterialien für eine Reihe von Anwendungszwecken noch nicht zufriedenstellend. Auch wird häufig ein höheres Auflösungsvermögen der Resistmaterialien verlangt.

In der EP-A-22 618, der EP-A-77 577 sowie der US-A-4 314 021 wird die Verwendung von monomeren Diacetylenen zur Herstellung von Photoresistschichten beschrieben. Hierbei werden, im allgemeinen mehrlagige, Schichten aus den monomeren Diacetylenen bildmäßig bestrahlt, wodurch in den bestrahlten Bereichen eine Photopolymerisation ausgelöst wird. Anschließend werden die unbestrahlten Bereiche der Resistschicht mit einem Entwicklerlösungsmittel entfernt. Diese Resistmaterialien zeigen bei hoher Quantenausbeute eine hohe Auflösung und liefern Resistmuster hoher mechanischer und chemischer Beständigkeit. Nachteilig ist u.a. die sehr umständliche und aufwendige Herstellung dieser photopolymerisierbaren Resistschichten aus den monomeren Diacetylenen, die bevorzugt unter Verwendung der Langmuir-Blodgett-Technik auf das Substrat aufgebracht werden. Diese Resistmaterialien sind ferner negativ arbeitend und nur gegenüber aktinischem Licht eines begrenzten Wellenlängenbereiches empfindlich. Für viele Anwendungszwecke sind jedoch positiv arbeitende Resistmaterialien von Vorteil, wobei vielfach auch eine breitere Empfindlichkeit wünschenswert ist.

Aufgabe der vorliegenden Erfindung war es, für den Einsatz in den an sich bekannten Verfahren zur Herstellung von bildmäßig strukturierten Resistmustern mit bildmäßiger Bestrahlung und Entwicklung von strahlungsempfindlichen Resistschichten ein neues, geeignetes, positiv arbeitendes, strahlungsempfindliches Resistmaterial aufzuzeigen, welches leicht und problemlos handhabbar, einfach verarbeitbar ist und ein hohes Auflösungsvermögen besitzt. Aufgabe der Erfindung war es weiterhin, ein derartiges Resistmaterial aufzuzeigen, welches Resistmuster mit guten anwendungstechnischen Eigenschaften, insbesondere mit guter mechanischer, thermischer und chemischer Beständigkeit, liefert. Aufgabe der Erfindung war es ferner, ein solches Resistmaterial zur Verfügung zu stellen, bei dem darüber hinaus mit aktinischer Strahlung in einem möglichst großen Wellenbereich gearbeitet werden kann und welches dabei nur kurze Belichtungszeiten erfordert. Aufgabe der Erfindung war es außerdem, ein Resistmaterial mit den genannten Eigenschaften aufzuzeigen, welches auch als Trockenfilmresist verarbeitbar ist.

Es wurde nun gefunden, daß diese Aufgabe durch strahlungsempfindliche, unter Einwirkung aktinischer Strahlung abbaubare Resistschichten auf der Basis von, insbesondere löslichen, Poly(diacetylenen) gelöst wird, die in einer besonderen Ausführungsform auch durch die aktinische Strahlung aktivierbare Sensibilisatoren enthalten können.

Gegenstand der Erfindung ist ein Trockenfilmresist, insbesondere zur Anwendung bei der Herstellung von gedruckten Schaltungen, Dünnschicht- oder Mehrschichtschaltungen, elektronischen Bauelementen und in der Halbleitertechnologie, mit einem dimensionsstabilen temporären Schichtträger, einer darauf aufgebrachten festen, laminierbaren, strahlungsempfindlichen, positiv arbeitenden Resistschicht auf Basis eines abbaubaren Polymeren sowie vorzugsweise einer Deckschicht auf der strahlungsempfindlichen Resistschicht, die von der strahlungsempfindlichen Resistschicht ohne gleichzeitiges Entfernen des temporären Schichtträgers abziehbar ist, wobei der Trockenfilmresist dadurch gekennzeichnet ist, daß die strahlungsempfindliche Resistschicht aus einem, insbesondere löslichen, Poly(diacetylen) aufgebaut ist.

Gegenstand der Erfindung ist weiterhin ein Verfahren zur Herstellung bildmäßig strukturierter Resistmuster auf einem Substrat, bei dem eine auf das Substrat aufgebrachte, feste, strahlungsempfindliche Resistschicht auf Basis eines abbaubaren Polymeren bildmäßig mit aktinischer Strahlung bestrahlt, hierbei das Polymere abgebaut und dadurch ein selektives Entfernen der bestrahlten Bereiche der Resistschicht ermöglicht wird, die bestrahlten Bereiche der Resistschicht dann entfernt werden und anschließend das so erhaltene Resistmuster gegebenenfalls nachbehandelt wird, welches dadurch gekennzeichnet ist, daß ein erfindungsgemäßer Trockenfilmresist eingesetzt wird, dessen strahlungsempfindliche Resistschicht aus einem, insbesondere löslichen, Poly(diacetylen) aufgebaut ist.

In einer besonderen, sehr vorteilhaften Ausführungsform des erfindungsgemäßen Verfahrens bzw. des erfindungsgemäßen Trockenfilmresists enthält die strahlungsempfindliche Resistschicht auf Basis der Poly(diacetylene) durch aktinische Strahlung aktivierbare Sensibilisatoren oder Sensibilisator-Systeme, die nach ihrer strahlungsmäßigen Aktivierung den Molekülabbau der Poly(diacetylene) zu induzieren bzw. beschleunigen vermögen.

Gemäß einer weiteren, ebenfalls vorteilhaften Ausgestaltungsform des erfindungsgemäßen Verfahrens wird die bildmäßig bestrahlte Resistschicht vor der Entwicklung des Resistmusters, d. h. vor der Entfernung der bestrahlten Bereiche, einer Temperung unterworfen. Diese Ausgestaltungsform kommt insbesondere dann zur Anwendung, wenn in der strahlungsempfindlichen Resistschicht keine durch Wärme aktivierbaren Sensibilisatoren für den Molekülabbau der Poly(diacetylene) enthalten sind und eine hohe Beständigkeit der Resistmuster angestrebt wird.

Andere spezielle und bevorzugte Ausführungsformen der Erfindung ergeben sich aus der nachfolgenden detaillierten Beschreibung.

Erfindungsgemäß basieren die strahlungsempfindlichen Resistschichten auf Poly(diacetylenen). Es hat sich gezeigt, daß die Poly(diacetylene) in festen Schichten durch Bestrahlung mit aktinischem Licht derart weitgehend und vollständig abgebaut werden können, daß hierdurch eine für die Entwicklung der Resistmuster notwendige Differenzierung zwischen den bestrahlten und unbestrahlten Bereichen erzielt wird und sich Resistmuster mit scharfen und exakten Konturen und ohne Restschichten auf den durch die Entwicklung freigelegten Bereichen des Substrates erhalten lassen. Dies war umso überraschender, als bislang Resistmuster aus Poly(diacetylenen) durch Photopolymerisation von monomeren Diacetylen-Schichten, d. h. durch Polymeraufbau mittels aktinischer Strahlung, hergestellt worden sind. Es hat sich weiterhin gezeigt, daß für die bildmäßige Bestrahlung der erfindungsgemäßen festen Resistschichten auf Basis der Poly(diacetylene) aktinische Strahlung in einem sehr breiten Wellenlängenbereich verwendet werden kann, wenn die Resistschichten eine homogene Mischung aus Poly(diacetylenen) und strahlungsaktivierbaren Sensibilisatoren, die nach ihrer Aktivierung den Molekülabbau der Poly(diacetylene) induzieren, enthalten. Hierdurch wird es — je nach Wahl der Sensibilisatoren oder Sensibilisator-Systeme — möglich, aktinische Strahlung vom Wellenlängenbereich des fernen UV bis hin zum Wellenlängenbereich der Wärme- und Infrarot-Strahlung für die Herstellung der Resistmuster zu nutzen. Außerdem erlaubt der Zusatz der Sensibilisatoren eine erhebliche Verkürzung der Zeiten für die bildmäßige Bestrahlung der Resistschichten und wird hierdurch auch die Anwendungsbreite der Resistmaterialien in den Verfahren zur Herstellung der Resistmuster vergrößert. Mit den erfindungsgemäßen, durch Bestrahlung abbaubaren Resistschichten auf Basis der Poly(diacetylene) können bei der bildmäßigen Strukturierung hohe Auflösungen erzielt werden, und es resultieren Resistmuster hoher Beständigkeit.

Vorteilhafterweise werden zur Ausbildung der erfindungsgemäßen, durch Bestrahlung mit aktinischer Strahlung abbaubaren Resistschichten, u. a. wegen ihrer leichteren Verarbeitbarkeit und Handhabbarkeit, lösliche Poly(diacetylene) eingesetzt. Die Poly(diacetylene) haben im allgemeinen ein mittleres Molekulargewicht (Gewichtsmittel, bestimmt durch Lichtstreuung) im Bereich von 10 000 bis 2 000 000, insbesondere im Bereich von 50 000 bis 1 000 000. Die erfindungsgemäß zu verwendenden Poly(diacetylene) sind als solche bekannt und können nach den an sich bekannten Verfahren hergestellt werden.

Erfindungsgemäß kommen dabei insbesondere solche Poly(diacetylene) zur Anwendung, die durch Polymerisation von monomeren Diacetylenen der allgemeinen Formel (I)

$$R^1{-}C{\equiv}C{-}C{\equiv}C{-}R^2 \qquad (I)$$

hergestellt worden sind und dementsprechend wiederkehrende Struktureinheiten der allgemeinen Formel (II) enthalten,

$$\!\!=\!\!\!\left[C(R^1){-}C{\equiv}C{-}C(R^2)\right]\!\!= \qquad (II)$$

In den Formeln (I) und (II) können $R^1$ und $R^2$ gleich oder verschieden sein und stehen unabhängig voneinander für einen organischen, insbesondere aliphatischen, aromatischen oder gemischt aliphatisch-aromatischen Rest, im allgemeinen mit 1 bis 50 C-Atomen, wobei diese Reste gesättigt oder ungesättigt sowie gegebenenfalls substituiert sein können und/oder insbesondere auch Heteroatome enthalten und/oder durch Heteroatome oder Heteroatome enthaltende Gruppen unterbrochen sein

können. Als Heteroatome sind hier vorzugsweise Sauerstoff, Stickstoff und/oder Schwefel zu nennen. Vorzugsweise enthalten die Reste $R^1$ und $R^2$ 10 oder mehr C-Atome. Insbesondere bevorzugt sind solche Reste $R^1$ und $R^2$, die Säureester-, Säureamid-, Sulfonat-, Urethan- und/oder Harnstoff-Gruppierungen enthalten. Bei den gebräuchlichen Diacetylenen sind die Reste $R^1$ und $R^2$ im allgemeinen gleich.

Als typische Vertreter für die Reste $R^1$ und $R^2$ in den allgemeinen Formeln (I) und (II) seien im Fall der löslichen Poly(diacetylene) genannt :

(a) 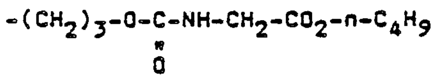

(b) 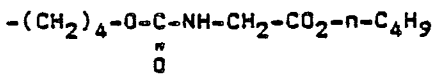

(c) 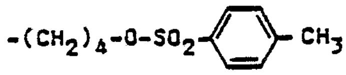

(d) 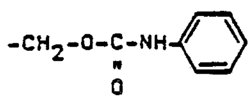

(e) 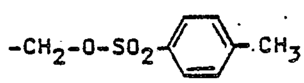

(f) 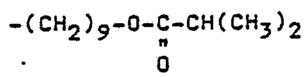

(g) 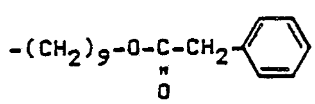

(h) 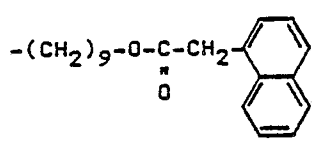

(i) $-(CH_2)_{11}-CH_3$

(k) 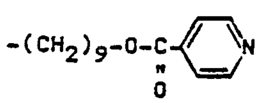

(l) 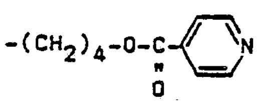

Entsprechende Poly(diacetylene) sowie ihre Herstellung sind beispielsweise beschrieben in J. Pol. Sci. Polymer Letters 16, 607 (1978) ; J. Chem. Phys. 70, 4387 (1979) ; J. Pol. Sci. Polymer Letters Ed. 17, 203 (1979) ; Makromol. Chem. Rapid Communication, 3, 231, 249 und 815 (1982). Als Lösungsmittel für die löslichen Poly(diacetylene) sind unter anderem Methylenchlorid, Chloroform, Dimethylformamid, Nitrobenzol, Dekalin geeignet. Als besonders vorteilhaft hat es sich erwiesen, für die Herstellung der durch Bestrahlung abbaubaren erfindungsgemäßen Resistschichten solche Poly(diacetylene) einzusetzen, aus denen die nach der Polymerisation im allgemeinen noch in den Polymeren enthaltenen nicht umgesetzten monomeren Diacetylene, beispielsweise durch Umfällen der Polymeren oder Extraktion mit geeigneten Lösungsmitteln, z. B. Aceton, entfernt worden sind.

Bei den erfindungsgemäß einzusetzenden Poly(diacetylenen) kann es sich sowohl um Homopolymerisate von monomeren Diacetylenen handeln als auch um Copolymerisate von 2 oder mehreren, verschiedenen monomeren Diacetylenen oder auch um Copolymerisate von 1 oder mehreren monomeren Diacetylenen mit einer untergeordneten Menge an anderen üblichen Comonomeren. Bevorzugt sind solche Poly(diacetylene), die ausschließlich aus Diacetylen-Einheiten bestehen. Die Poly(diacetylene)

können zur Herstellung der erfindungsgemäßen strahlungsempfindlichen Resistschichten allein oder auch in Mischung miteinander eingesetzt werden. Die Resistschichten können dabei allein aus den Poly(diacetylenen) bestehen, sie können aber vorteilhafterweise auch noch Zusatz- und/oder Hilfsstoffe enthalten.

In einer bevorzugten Ausführungsform der Erfindung sind in den durch Bestrahlung mit aktinischer Strahlung abbaubaren Resistschichten neben den Poly(diacetylenen) Sensibilisatoren bzw. Sensibilisator-Systeme enthalten, die durch die Bestrahlung mit der aktinischen Strahlung aktiviert werden können und nach ihrer Aktivierung den Molekülabbau der Poly(diacetylene) induzieren bzw. beschleunigen. Bei den strahlungsaktivierbaren Sensibilisatoren kann es sich um solche handeln, die durch aktinisches Licht, insbesondere im Wellenlängenbereich von etwa 180 bis etwa 800 nm, aktiviert werden können, oder auch um solche, die durch Wärmestrahlung, insbesondere IR-Strahlung einer Wellenlänge größer etwa 0,8 µm, aktiviert werden können.

Zu den lichtaktivierbaren Sensibilisatoren gehören solche Verbindungen, die unter dem Einfluß von aktinischem Licht, insbesondere des oben genannten Wellenlängenbereiches, unmittelbar freie, reaktive Radikale bilden. Als Beispiel hierfür sei Azobisisobutyronitril genannt. Als lichtaktivierbare Sensibilisatoren eignen sich aber auch Verbindungen mit einer oder mehreren Absorptionsbanden in dem Wellenlängenbereich des aktinischen Lichtes, die bei Bestrahlung mit dem aktinischen Licht in einen angeregten, energiereicheren Zustand, wie z. B. sehr häufig den Triplett-Zustand, übergehen und die aus diesem angeregten Zustand heraus den Abbau der Poly(diacetylene), sei es durch Energieübertragung und/oder insbesondere auch über radikalische Reaktionen, induzieren bzw. beschleunigen. Zu den lichtaktivierbaren Sensibilisatoren dieser Kategorie gehören z. B. Xanthen-Farbstoffe, von denen u. a. Rhodamin 6G besonders vorteilhafte Ergebnisse geliefert hat ; Thiazinium-Farbstoffe, wie etwa Methylenblau ; aber auch mehrkernige Chinone und deren Derivate, wie insbesondere Anthrachinon oder Anthrachinon-Derivate ; sowie Arylketone, wobei hier insbesondere Benzophenon oder Mischungen von Benzophenon und Michler's Keton genannt seien.

Bei den wärmeaktivierbaren Sensibilisatoren handelt es sich im allgemeinen um Verbindungen, die in der Wärme freie, reaktive Radikale bilden und dann über eine radikalische Reaktion mit den Poly(diacetylenen) deren Molekülabbau bewirken. Bei den wärmeaktivierbaren Sensibilisatoren handelt es sich somit in aller Regel um radikalische oder unter dem Einfluß von Wärme in freie Radikale zerfallende Verbindungen, die in der Wärme mit den Poly(diacetylenen) reagieren. Als wärmeaktivierbare Sensibilisatoren sind solche Verbindungen bevorzugt, die unter dem Einfluß von Wärme, insbesondere bei Temperaturen im Bereich von etwa 40 bis 200 °C, freie Radikale bilden. Hierzu gehören insbesondere die üblichen und bekannten radikalischen Polymerisationskatalysatoren. Beispielhaft und stellvertretend genannt seien Azobisisobutyronitril und Benzoylperoxid.

Die strahlungsaktivierbaren Sensibilisatoren können in den erfindungsgemäßen Resistschichten auf Basis der Poly(diacetylene) allein oder in Mischung miteinander vorliegen. Je nach Art der eingesetzten Sensibilisatoren bzw. verwendeten Sensibilisator-Systeme resultiert so eine große Vielfalt von verfahrens- und anwendungstechnischen Möglichkeiten, die eine breite Ausgestaltung und Variation des erfindungsgemäßen Verfahrens erlaubt. So ist es beispielsweise möglich, einen lichtaktivierbaren Sensibilisator einzusetzen, der im Wellenlängenbereich von etwa 250 bis 320 nm, d. h. also größtenteils dem Bereich der Eigenabsorption der Poly(diacetylene), absorbiert. In diesem Fall wird der Photoabbau der Poly(diacetylene) durch den Sensibilisator um beispielsweise das Drei- bis Vierfache beschleunigt. In einer anderen Ausführungsform können lichtaktivierbare Sensibilisatoren eingesetzt werden, deren Absorptionsmaxima außerhalb der Eigenabsorption der Poly(diacetylene) liegen, beispielsweise im Wellenlängenbereich von etwa 400 bis 800 nm, wie bei den im sichtbaren Bereich absorbierenden Farbstoffen. In diesem Fall ist es möglich, für die Bestrahlung der Resistschichten einfachere und problemloser zu handhabende Lichtquellen zu verwenden, ohne daß Einbußen in der Qualität des erhaltenen Resistmusters hingenommen werden müssen. Der Einsatz von wärmeaktivierbaren Sensibilisatoren macht beispielsweise die Verwendung von IR-Lasern für die bildmäßige Bestrahlung der Resistschichten möglich. In einer weiteren Ausgestaltungsform können Mischungen aus zwei oder mehreren lichtaktivierbaren Sensibilisatoren eingesetzt werden, deren Absorptionsmaxima in unterschiedlichen Wellenlängenbereich liegen. Hierdurch ist es beispielsweise möglich, das Emissionsspektrum der Lichtquellen für das aktinische Licht besser und vollständiger auszunutzen. In der strahlungsempfindlichen Resistschicht können auch Mischungen aus lichtaktivierbaren Sensibilisatoren und wärmeaktivierbaren Sensibilisatoren enthalten sein. Dies ist unter anderem für die im nachfolgenden noch beschriebene Methode der Mehrfachbestrahlung der Resistschichten von Vorteil, da in diesem Fall unter Verwendung von nur einer photografischen Bildvorlage, deren Bildbereiche für aktinische Strahlung verschiedener Wellenlänge in unterschiedlichem Maße durchlässig bzw. undurchlässig sind, eine mehrfache bildmäßige Bestrahlung der Resistschicht möglich wird. Die strahlungsaktivierbaren Sensibilisatoren bzw. Sensibilisator-Systeme sind in der Resistschicht auf Basis der Poly(diacetylene) im allgemeinen in Mengen von 0,001 bis 10 Gew.-%, vorzugsweise in Mengen von 0,05 bis 5 Gew.-%, bezogen auf die gesamte, strahlungsempfindliche Resistschicht, enthalten.

In der erfindungsgemäßen, durch Bestrahlung abbaubaren Resistschichten auf Basis der Poly(diacetylene) können, gegebenenfalls zusammen mit den strahlungsaktivierbaren Sensibilisatoren, auch noch weitere Zusatz- und/oder Hilfsstoffe enthalten sein, wie z. B. Weichmacher, Pigmente,

Füllstoffe, Antioxidantien. Als Weichmacher haben sich dabei insbesondere Dibutylphthalat, Bis(2-ethylhexyl)phthalat bewährt. Diese weiteren Zusatz- und/oder Hilfsstoffe sind in den strahlungsempfindlichen Resistschichten im allgemeinen in Mengen nicht über 40 Gew.-%, insbesondere in Mengen bis zu 30 Gew.-%, bezogen auf die gesamte, strahlungsempfindliche Resistschicht, enthalten.

Die erfindungsgemäßen, durch Bestrahlung mit aktinischer Strahlung abbaubaren Resistschichten auf Basis der Poly(diacetylene) können auf die zu schützenden und gegebenenfalls anschließend zu modifizierenden Substrate nach den üblichen und an sich bekannten Auftragstechniken aufgebracht werden. Geeignet ist z. B. das Aufbringen der strahlungsempfindlichen Resistschicht aus Lösung, wobei eine Lösung der die Resistschicht bildenden Komponenten, d. h. also der Poly(diacetylene) und der gegebenenfalls mitverwendeten Zusatz- und/oder Hilfsstoffe, in einem geeigneten Lösungsmittel, beispielsweise der weiter oben genannten Art, in der gewünschten Schichtdicke nach den bekannten Beschichtungsverfahren, z. B. durch spin-coating, Gießen, Tauchbeschichtung, Lippengießen, auf das Substrat aufgebracht, das Lösungsmittel abgedampft und die Resistschicht getrocknet wird. Diese Lösungsbeschichtung des Substrats ist insbesondere dann empfehlenswert, wenn die lichtempfindlichen Resistschichten sehr dünn gehalten werden sollen und ihre Trockenschichtdicke unter etwa 0,5 bis 2 µm, vorzugsweise im Bereich von 10 nm bis 2 µm, liegt. Bei dickeren Resistschichten, etwa im Bereich von 0,5 bis 100 µm, ist auch das Aufbringen einer trockenen, vorgefertigten Resistschicht auf das Substrat unter Anwendung von Druck sowie gegebenenfalls Wärme nach den üblichen Laminierverfahren sehr vorteilhaft.

Zum Aufbringen von festen, vorgefertigten strahlungsempfindlichen Resistschichten auf das Substrat geht man am besten von einem Trockenfilmresist (Schichtübertragungsmaterial) aus, der auf einem temporären, dimensionsstabilen Schichtträger die erfindungsgemäße strahlungsempfindliche und durch Bestrahlung abbaubare Resistschicht auf Basis der Poly(diacetylene) aufgebracht enthält.

Als temporäre Schichtträger für die Trockenfilmresists kommen die hierfür üblichen und an sich bekannten Materialien, insbesondere Kunststoffilme oder -folien, z. B. aus Polyestern, in Betracht. Der temporäre, dimensionsstabile Schichtträger hat im allgemeinen eine mäßige Haftung zu der strahlungsempfindlichen Resistschicht auf Basis der Poly(diacetylene), die insbesondere geringer ist als die Haftung der strahlungsempfindlichen Resistschicht gegenüber dem Substrat nach dem Auflaminieren. Dadurch ist gewährleistet, daß der temporäre Schichtträger nach dem Auflaminieren der strahlungsempfindlichen Resistschicht auf das Substrat, wahlweise vor oder nach der bildmäßigen Bestrahlung der Resistschicht, von dieser abgezogen werden kann, ohne daß hierbei die Resistschicht wieder vom Substrat gelöst wird. Der temporäre, dimensionsstabile Schichtträger der erfindungsgemäßen Trockenfilmresists kann — wenn die Entwicklung des Resistmusters mit einem Entwicklerlösungsmittel erfolgt — auch aus einem Material bestehen, das in dem Entwicklerlösungsmittel löslich ist, so daß in diesem Fall das Abziehen des temporären Schichtträgers nach dem Auflaminieren der Resistschicht auf das Substrat entfallen kann und somit auch die vorstehend angesprochene Haftungsdifferenzierung nicht notwendig ist. Das Aufbringen der erfindungsgemäßen strahlungsempfindlichen Resistschicht auf Basis der Poly(diacetylene) auf den temporären, dimensionsstabilen Schichtträger kann ebenfalls nach den an sich bekannten und üblichen Verfahren, insbesondere aus Lösung nach den oben angesprochenen Auftragstechniken, erfolgen.

Die Trockenfilmresists enthalten vorteilhafter-, aber nicht zwingenderweise, auf der freien Oberfläche der strahlungsempfindlichen Resistschicht noch eine Deckschicht aufgebracht, die insbesondere dem Schutz der strahlungsempfindlichen Resistschicht bei der Handhabung des Trockenfilmresists dient. Diese Deckschicht, die vorzugsweise aus dünnen Kunststoffilmen oder -folien gebildet wird, wie beispielsweise Polyethylen, Polypropylen und dergleichen, soll gegenüber der strahlungsempfindlichen Resistschicht eine geringere Haftung aufweisen als der temporäre Schichtträger, damit sie vor dem Auflaminieren der Resistschicht auf das Substrat problemlos von dieser abgezogen werden kann. Gegebenenfalls kann zwischen Deckschicht und strahlungsempfindlicher Resistschicht bzw. temporären Träger und strahlungsempfindlicher Resistschicht, in an sich bekannter Weise, jeweils auch noch eine Zwischenschicht angeordnet sein, die in dem für das Auswaschen der bildmäßig bestrahlten Resistschichtbereiche, d. h. die Entwicklung des Resistmusters verwendeten Entwicklerlösungsmittel löslich ist.

Um bei Einsatz der erfindungsgemäßen Trockenfilmresists das Auflaminieren der strahlungsempfindlichen Resistschicht auf das Substrat zu erleichtern, werden in diesem Fall bevorzugt solche Resistschichten eingesetzt, die Weichmacher enthalten. In einer bevorzugten Verfahrensvariante wird dabei vor dem Auflaminieren der strahlungsempfindlichen Resistschicht auf das Substrat diese von der dem temporären Schichtträger abgewandten Oberfläche her, d. h. also von der Seite her, die auf das Substrat auflaminiert wird, kurzzeitig vollflächig mit aktinischer Strahlung vorbestrahlt. Hierdurch wird eine erhebliche Verkürzung der Zeiten für die nachfolgende bildmäßige Bestrahlung der Resistschicht ermöglicht, ohne daß durch diese vollflächige Vorbestrahlung die bildmäßige Differenzierung und Strukturierung der Resistschicht bei der bildmäßigen Hauptbestrahlung nachteilig beeinflußt wird. Eine solche Vorbestrahlung hat sich daher insbesondere dann als vorteilhaft erwiesen, wenn Trockenfilmresists mit relativ dicken strahlungsempfindlichen Resistschichten, z. B. im Bereich von einigen µm und mehr, eingesetzt werden, da in diesen Fällen sonst vergleichsweise lange Bestrahlungszeiten für eine vorlagengetreue Bildstrukturierung der Resistschicht mit gut ausgeprägten Konturen und ohne Resistschicht-Anteilen auf

dem Substrat erforderlich wären.

Die erfindungsgemäßen strahlungsempfindlichen Resistschichten auf Basis der Poly(diacetylene) sind, wenn sie aus Lösung hergestellt worden sind, teilkristallin. Wegen ihrer hohen mechanischen und chemischen, sowie bei Abwesenheit von durch Wärme aktivierbaren Sensibilisatoren auch hohen thermischen, Beständigkeit können die erfindungsgemäßen strahlungsempfindlichen Resistschichten vergleichsweise dünn gehalten werden, wobei ihre Schichtdicke im allgemeinen im Bereich von etwa 10 nm bis 100 µm liegt. Die Dicke der strahlungsempfindlichen Resistschicht richtet sich in bekannter Weise nach dem jeweiligen Anwendungszweck. Dabei werden sehr dünne Schichten, beispielsweise im Bereich von etwa 10 nm bis 2 µm, wie sie beispielsweise bei der Herstellung von Dünnschichtschaltungen, Mehrschichtschaltungen oder in der Halbleitertechnik Anwendung finden können, aus Lösung auf das Substrat aufgebracht. Hingegen können dickere Schichten, etwa im Bereich von 0,5 µm bis 10 µm oder darüber, wie sie neben diesen genannten Anwendungsbereichen beispielsweise auch bei der Herstellung von Leiterplatten und gedruckten Schaltungen Verwendung finden, auch trocken nach den Laminierverfahren auf das Substrat aufgebracht werden.

Als Substrat, dessen Art sich bekanntermaßen nach dem jeweiligen Anwendungszweck des herzustellenden Resistmusters richtet, kommen die in diesem Bereich üblichen und bekannten Substanzen in Betracht. So werden beispielsweise für die Herstellung von Ätz- oder Galvano-Resisten, wie sie etwa bei der Fertigung von Leiterplatten oder gedruckten Schaltungen benötigt werden, als Substrate Kupferbleche oder kupferkaschierte Basismaterialien verwendet. Für die Herstellung von Dünnschichtschaltungen oder Mehrschichtschaltungen werden insbesondere Keramiksubstrate, die mit metallischen oder metalloxidischen Schichten beschichtet sind, oder Halbleiterelemente verarbeitet. In der Halbleitertechnik dienen als Substrate häufig Silicium-, GaAs- oder InSb-Scheiben, die oberflächlich mit einer Oxid- oder allgemeinen Isolierschicht versehen sein können. Gegebenenfalls kann es nützlich sein, das Substrat vor dem Aufbringen der strahlungsempfindlichen Resistschicht mit einem Haftvermittler zu behandeln. Dies ist insbesondere in der Halbleitertechnik von Vorteil, wenn als Substrat Silicium- oder siliciumdioxidmodifizierte Scheiben eingesetzt werden, wobei sich in diesem Fall als Haftvermittler beispielsweise Hexamethylendisilazan besonders bewährt hat.

Nach dem Aufbringen der erfindungsgemäßen, strahlungsempfindlichen, abbaubaren Resistschicht auf Basis der Poly(diacetylene) auf das Substrat wird die strahlungsempfindliche Resistschicht zur Erzeugung einer bildmäßigen Strukturierung zur Ausbildung des gewünschten Resistmusters bildmäßig mit aktinischer Strahlung bestrahlt. Die Art der aktinischen Strahlung richtet sich dabei maßgeblich nach den in der Resistschicht gegebenenfalls enthaltenen Sensibilisatoren bzw. Sensibilisator-Systemen. Sind in der Resistschicht keine den Abbau der Poly(diacetylene) induzierenden Sensibilisatoren enthalten, so wird zweckmäßig für die bildmäßige Bestrahlung der Resistschicht aktinisches Licht im Wellenlängenbereich von etwa 200 bis 450 nm, insbesondere im Wellenlängenbereich von 250 bis 320 nm, verwendet.

Im anderen Fall kommt für die bildmäßige Bestrahlung der Resistschicht in Abhängigkeit von den in der Resistschicht enthaltenen Sensibilisatoren sowohl aktinisches Licht, insbesondere im Wellenlängenbereich von etwa 180 nm bis 800 nm, als auch Wärmestrahlung, insbesondere IR-Strahlung einer Wellenlänge größer etwa 0,8 µm, in Betracht. Die Strahlungsquelle wird dabei vorteilhafterweise auf die in der Resistschicht enthaltenen Sensibilisatoren oder Sensibilisator-Systeme abgestellt. In Fall von aktinischem Licht werden bevorzugt solche Strahlungsquellen eingesetzt, die im Absorptionsbereich der lichtaktivierbaren Sensibilisatoren eine möglichst große Emission besitzen. Bei Strahlungsquellen, die über einen breiten Wellenlängenbereich emittieren, ist es möglich, die Strahlungsintensität durch Einsatz geeigneter Sensibilisatoren bzw. Sensibilisator-Systeme besser und vollständiger als bisher auszunutzen.

Als Strahlungsquellen kommen dementsprechend einerseits Wärmestrahler, insbesondere IR-Strahler oder IR-Laser, in Betracht, andererseits die üblichen Strahlungsquellen für aktinisches Licht im UV- und sichtbaren Wellenlängenbereich, wie beispielsweise Glühlampen, Halogenbrenner, Quecksilbernieder-, -mittel- oder -hochdrucklampen, die gegebenenfalls z. B. mit Eisen oder Gallium dotiert sein können, Xenonlampen, Leuchtstoffröhren, superaktinische Leuchtstoffröhren, Excimerlaser, UV-Laser. Die bildmäßige Bestrahlung der Resistschicht kann mittels eines bildmäßig modulierten Laserstrahls erfolgen oder bei Verwendung von diffuser Strahlung unter Einsatz einer geeigneten, beispielsweise fotografischen Bildvorlage, etwa eines fotografischen Negativs oder Positivs, deren Opak-Bereiche für die verwendete aktinische Strahlung praktisch undurchlässig sind.

Die Dauer für die bildmäßige Bestrahlung der Resistschicht hängt neben der Zusammensetzung der Strahlungsempfindlichen Resistschicht, insbesondere der Art der verwendeten Poly(diacetylene) und gegebenenfalls Sensibilisatoren, auch von ihrer Schichtdicke, der Strahlungsintensität sowie der verwendeten Strahlungsquelle ab. Da durch die Bestrahlung mit der aktinischen Strahlung ein Molekülabbau der Poly(diacetylene) induziert und hierdurch eine Eigenschaftsdifferenzierung zwischen bestrahlten und unbestrahlten Bereichen der Resistschicht bewirkt wird, wird die Bestrahlungsdauer so gewählt, daß nach der bildmäßigen Bestrahlung die bestrahlten Bereiche vollständig mittels eines geeigneten Entwicklermediums entfernt werden können. Die Zeit für die bildmäßige Bestrahlung liegt dabei üblicherweise im Bereich von einigen Sekunden bis einigen Minuten, wobei die optimalen Bestrahlungsbedingungen in bekannter Weise anhand von einfachen Vorversuchen leicht festgestellt werden können. Bei Einsatz von Wärmestrahlung hat es sich als zweckmäßig erwiesen, die bildmäßige Bestrahlung der Resistschicht so durchzuführen, daß die bestrahlten Bereiche auf eine Temperatur im

Bereich von etwa 40 bis 200 °C, jedoch mindestens auf eine Temperatur über der Aktivierungstemperatur des enthaltenen wärmeaktivierbaren Sensibilisators, erwärmt werden. Wird bei Verwendung der erfindungsgemäßen Trockenfilmresists die strahlungsempfindliche Resistschicht vor dem Auflaminieren auf das Substrat, wie oben erwähnt, kurzzeitig vollflächig vorbestrahlt, so kann die Dauer für diese Vorbestrahlung bis etwa 70 % der Dauer für die bildmäßige Hauptbestrahlung betragen. Vollflächige Vorbestrahlung und bildmäßige Hauptbestrahlung können dabei mit der gleichen oder auch mit verschiedenen Strahlungsquellen vorgenommen werden. Sind beispielsweise in der strahlungsempfindlichen Resistschicht sowohl lichtaktivierbare als auch wärmeaktivierbare Sensibilisatoren enthalten, kann die vollflächige Vorbestrahlung beispielsweise mittels IR-Strahlung vorgenommen werden, wohingegen für die bildmäßige Hauptbestrahlung aktinisches Licht verwendet werden kann oder auch umgekehrt.

Nach der bildmäßigen Bestrahlung der Resistschicht und vor der Entwicklung des Resistsmusters kann die Resistschicht gewünschtenfalls noch einer Temperung unterzogen werden, bei der man die Resistschicht auf erhöhte Temperaturen, insbesondere im Bereich von etwa 50 bis 200 °C, erwärmt. Durch einen solchen Temperschritt kann der kristalline Anteil der Poly(diacetylene) in der Resistschicht erhöht und damit die Beständigkeit der Resistschicht verbessert werden. Sind in der Resistschicht wärmeaktivierbare Sensibilisatoren enthalten, die bei ihrer Aktivierung den Molekülabbau der Poly(diacetylene) induzieren würden, so ist es selbstverständlich, daß die Temperatur für eine solche Temperung unterhalb der Aktivierungstemperatur der wärmeaktivierbaren Sensibilisatoren liegen muß. Vorzugsweise wird eine solche Temperung der Resistschicht nach der bildmäßigen Bestrahlung dann vorgenommen, wenn die Resistschicht keine wärmeaktivierbaren Sensibilisatoren enthält und hohe Anforderungen an die Beständigkeit der Resistmuster gestellt werden, beispielsweise auch wenn das Resistmuster trocken mittels eines Plasma-Gases entwickelt werden soll. Die Dauer für einen solchen Temperschritt liegt üblicherweise in Bereich von 10 bis 2 000 Minuten und wird im wesentlichen durch das angestrebte Eigenschaftsbild des Resistmusters mitbestimmt.

Nach der bildmäßigen Bestrahlung der Resistschicht sowie einer gegebenenfalls anschließenden Temperung werden die bestrahlten Bereiche der Schicht unter Entwicklung des Resistmusters entfernt. Dieses kann beispielsweise durch Auswaschen der bestrahlten Bereiche mit einem Entwicklerlösungsmittel, wie beispielsweise Aceton, erfolgen. Das Auswaschen kann in üblicher Weise etwa durch Besprühen, Ausreiben oder Ausbürsten der bildmäßig bestrahlten Resistschicht mit dem Entwicklerlösungsmittel vorgenommen werden. Ein besonderer Vorteil der erfindungsgemäß einzusetzenden Resistschichten liegt auch darin, daß nach der bildmäßigen Bestrahlung die Entwicklung des Resistmusters anstatt mit einem Entwicklerlösungsmittel gleichermaßen trocken, beispielsweise durch Plasma- oder Vakuumbehandlung, durchgeführt werden kann. Bei der Plasma-Entwicklung wird die bildmäßig bestrahlte Resistschicht beispielsweise mit Plasma-Gasen, wie Ar, $C_2F_2$, $C_2F_4$, $O_2$, behandelt und werden hierdurch die bestrahlten, abgebauten Schichtbereiche entfernt. Diese trockene Entwicklung durch Plasma-Behandlung ist als solche grundsätzlich bekannt.

Nach dem Entwickeln des Resistmusters durch Entfernen der bestrahlten Bereiche der Resistschicht kann das erhaltene Resistmuster gegebenenfalls noch nachbehandelt werden. Hierzu gehört insbesondere die Trocknung des Resistmusters nach dem Auswaschen der bestrahlten Schichtbereiche mit einem Entwicklerlösungsmittel. Als Nachbehandlung kommt aber auch z. B. eine Temperung des Resistmusters in Betracht, wie sie oben bereits als Zwischenschritt zwischen der bildmäßigen Bestrahlung und der Entwicklung des Resistmusters beschrieben worden ist. Obwohl die Temperung in zwei Schritten, d. h. sowohl nach der bildmäßigen Bestrahlung als auch nach der Entwicklung, vorgenommen werden kann, hat es sich in der Praxis als sinnvoll erwiesen, die Temperung zur Verbesserung der Resistenz der Resistschicht entweder nach der bildmäßigen Bestrahlung oder nach der Entwicklung durchzuführen, wobei die Temperung nach der Entwicklung des Resistmusters vorzugsweise dann angewandt wird, wenn die Entwicklung des Resistmusters mit einem Entwicklerlösungsmittel durchgeführt wird und/oder, wie nachfolgend beschrieben, eine mehrfache bildmäßige Bestrahlung und Entwicklung der Resistschicht vorgesehen ist.

Nach der Entwicklung des Resistmusters können die freigelegten Bereiche des Substrates in an sich bekannter und üblicher Weise, beispielsweise durch Metallabscheidung, Ätzen oder Dotieren, dauerhaft modifiziert werden. Der Vorgang der bildmäßigen Bestrahlung und Entwicklung der Resistschicht kann gewünschtenfalls mehrmals wiederholt werden, wobei nach jedem Entwicklungsschritt und vor jeder weiteren bildmäßigen Bestrahlung die freigelegten Bereiche des Substrats modifiziert werden können. Die Mehrfachbestrahlung erlaubt somit eine wiederholte, verschiedenartige Modifizierung des Substrates, z. B. die galvanische Vergoldung von Steckkontaktleisten oder die Herstellung von Platinen, die inmitten der Leiterbahnzüge mit Edelmetallen galvanisch verstärkte Druckpunkt- oder Schleifkontaktschalter besitzen. Ein besonderer Vorteil der erfindungsgemäßen, strahlungsempfindlichen Resistmaterialien liegt dabei darin, daß bei einer solchen mehrfachen bildmäßigen Bestrahlung der Resistschicht mit nur einer fotografischen Bildvorlage gearbeitet werden kann, wenn die Resistschicht eine Mischung aus Sensibilisatoren enthält, die mit aktinischer Strahlung unterschiedlicher Wellenlänge aktiviert werden können und die verschiedenen bildmäßigen Bereiche der fotografischen Bildvorlage jeweils nur für bestimmte Wellenlängen der aktinischen Strahlung durchlässig bzw. undurchlässig sind.

Die nach dem beschriebenen Verfahren mit den erfindungsgemäßen strahlungsempfindlichen

Resistschichten auf Basis der Poly(diacetylene) hergestellten Resistmuster eignen sich für alle Anwendungszwecke, die für bildmäßig strukturierte Resistschichten bekannt sind, wie z. B. als Ätz- und Galvanoresist in der Herstellung von Leiterbahnen, gedruckten Schaltungen, für die Herstellung von Dünnschicht- oder Mehrschichtschaltungen, elektronischen Bauelementen, in der Halbleitertechnik. Die erfindungsgemäß hergestellten Resistmuster zeichnen sich durch eine gute mechanische, chemische und — sofern keine wärmeaktivierbaren Sensibilisatoren enthalten sind — auch thermische Beständigkeit aus. Erfindungsgemäß lassen sich hohe Auflösungen erzielen, so daß feinste Bildelemente vorlagengetreu in dem erhaltenen Resistmuster wiedergegeben werden. Dabei ist auch die Tatsache von Vorteil, daß sich die erfindungsgemäß einzusetzenden Resistschichten für die Bestrahlung mit aktinischer Strahlung in einem sehr breiten Wellenlängenbereich hervorragend eignen, und zwar über den gesamten Bereich vom fernen UV- bis in den IR-Bereich. Dies ermöglicht eine sehr breite und allgemeine Anwendbarkeit der erfindungsgemäßen Resistmaterialien und gestattet große Variationsmöglichkeiten bei der Herstellung der Resistmuster. Trotz der Teilkristallinität der erfindungsgemäß einzusetzenden Resistschichten zeigen diese eine hohe optische Transparenz. Für die Anwendung bedeutungsvoll ist auch die Tatsache, daß die bildmäßig bestrahlten Resistschichten trocken entwickelt werden können.

Die Erfindung wird durch die nachfolgenden Beispiele näher erläutert. Die in den Beispielen genannten Teile und Prozente beziehen sich, sofern nicht anders angegeben, auf das Gewicht.

## Beispiel 1

4,6-Decadiin-1,10-diol-bis(n-butoxycarbonylmethylurethan) wurde durch Bestrahlen mit gamma-Strahlung (3 Megarad) polymerisiert. Das mit 30 %iger Ausbeute erhaltene kristalline Poly(diacetylen) (P3BCMU) entsprach der allgemeinen Formel (II) mit $R^1 = R^2$ und dem in der Beschreibung unter (a) angegebenen Rest für die Substituenten $R^1$ und $R^2$. Aus dem erhaltenen Poly(diacetylen) wurde das nicht umgesetzte Monomere durch Extraktion mit Aceton entfernt. Man erhielt metallisch glänzende Fasern, die in Chloroform gelöst wurden. Die Lösung wurde durch spin-coating auf eine oberflächlich oxidierte Silicum-Scheibe aufgebracht, so daß nach dem Trocknen eine teilkristalline Polymerschicht von etwa 40 nm Dicke resultierte. Diese Poly(diacetylen)-Schicht wurde mit einer 1 000 Watt Xenon-Quecksilberhöchstdrucklampe durch eine fotographische Bildvorlage 2 Minuten lang belichtet. Anschließend konnten die belichteten Bereiche der Poly(diacetylen)-Schicht mit Aceton ausgewaschen werden. Man erhielt ein originalgetreues Resistmuster mit gut ausgebildeten Konturen. Die freigelegten Bereiche des Trägers konnten in üblicher Weise geätzt werden.

## Beispiel 2

Es wurde wie in Beispiel 1 beschrieben verfahren, jedoch mit dem Unterschied, daß diesmal ein Poly(diacetylen) der allgemeinen Formel (II) eingesetzt wurde, in dem die Reste $R^1 = R^2$ dem in der Beschreibung angegebenen Rest (c) entsprachen. Die Belichtungszeit konnte, bei etwa gleicher optischer Dichte im Wellenlängenbereich des Absorptionsmaximums wie in Beispiel 1, dabei auf 1/2 Minute reduziert werden. Im übrigen wurden die gleichen Ergebnisse erhalten wie in Beispiel 1.

## Beispiel 3

Es wurde wie in Beispiel 1 gearbeitet, nach der bildmäßigen Belichtung diesmal jedoch 12 h bei 110 °C getempert und die Entwicklung des Resistmusters durch eine Plasma-Behandlung mit $Ar/O_2$-Plasma-Gas durchgeführt. Es wurde ein gut ausgebildetes, vorlagengetreues Resistmuster mit noch besserer Qualität als in Beispiel 1 erhalten.

## Beispiel 4

4,6-Decadiin-1,10-diol-bis(n-butoxycarbonylmethylurethan) wurde durch $\gamma$-Strahlung (3 Megarad einer $^{60}Co$-$\gamma$-Quelle) polymerisiert. Das mit 30 %iger Ausbeute erhaltene Poly(diacetylen) (P3BCMU) bestand aus Struktureinheiten der allgemeinen Formel (II) mit $R^1 = R^2$ und dem in der Beschreibung unter (a) angegebenen Rest für $R^1$ und $R^2$. Aus dem erhaltenen Polymeren wurde das nicht umgesetzte Monomere durch Extraktion mit Aceton entfernt. Die erhaltenen, metallisch glänzenden Fasern wurden in Chloroform gelöst, und die Lösung wurde durch spin-coating so auf ein Glassubstrat aufgebracht, daß nach dem Trocknen eine teilkristalline Polymerschicht von etwa 10 nm Dicke resultierte. Diese Poly(diacetylen)schicht wurde mit einer Quecksilber-Höchstdrucklampe HBO 200 W durch eine fotografische Bildvorlage 4 min lang belichtet. Die optische Dichte der Schicht bei der Wellenlänge von 500 nm verringerte sich hierbei von 0,19 auf 0,05. Anschließend wurden die belichteten Bereiche der Poly(diacetylen)schicht mit Aceton ausgewaschen. Man erhielt ein originalgetreues Resistmuster mit gut ausgebildeten Konturen.

## Beispiel 5

Es wurde wie in Beispiel 4 beschrieben verfahren, jedoch mit dem Unterschied, daß diesmal 1 Gew.-% Anthrachinon zu dem in Chloroform gelösten Poly(diacetylen) hinzugegeben wurde. Die Belichtungszeit konnte hierdurch auf 3,25 min gesenkt werden, um die gleiche Abnahme der optischen Dichte bei einer Wellenlänge von 550 nm und ein Resistmuster gleicher Qualität zu erreichen wie in Beispiel 4.

Beispiel 6

Es wurde wie in Beispiel 4 beschrieben verfahren, jedoch mit dem Unterschied, daß diesmal zu dem in Chloroform gelösten P3BCMU 30 % des Weichmachers Bis(2-ethyl-hexyl)phthalat hinzugegeben wurden. Die Belichtungszeit betrug diesmal 7,5 min, um die gleiche Änderung der optischen Dichte bei einer Wellenlänge von 550 nm zu erreichen wie in Beispiel 4.

Beispiel 7

Es wurde wie in Beispiel 6 beschrieben verfahren, jedoch mit dem Unterschied, daß diesmal zu dem in Chloroform gelösten Gemisch aus P3BCMU und Weichmacher 1 % Anthrachinon hinzugegeben wurde. Die Belichtungszeit konnte auf 4,5 min gesenkt werden, um die gleiche Änderung der optischen Dichte, wie in Beispiel 4 beschrieben, zu erreichen. Es wurde ein Resistmuster guter Qualität erhalten.

Beispiel 8

Es wurde wie in Beispiel 4 beschrieben verfahren, jedoch mit dem Unterschied, daß diesmal als Poly(diacetylen) P4BCMU eingesetzt wurde, bei dem in der allgemeinen Formel (II) die Reste $R^1 = R^2$ dem in der Beschreibung unter (b) angegebenen Rest entsprechen. Um bei der Wellenlänge von 535 nm eine Änderung der optischen Dichte von 0,30 auf 0,13 zu erreichen, mußte die Resistschicht 3,75 min belichtet werden. Das erhaltene Resistmuster war gut ausgebildet.

Beispiel 9

Es wurde wie in Beispiel 8 verfahren, jedoch mit dem Unterschied, daß zu dem in Chloroform gelösten P4BCMU 2 % Michler's Keton und 6 % Benzophenon hinzugegeben wurden. Um die gleiche Änderung der optischen Dichte wie in Beispiel 8 zu erreichen, brauchte nur 3,25 min belichtet zu werden. Die Qualität des Resistmusters war der von Beispiel 8 vergleichbar.

Beispiel 10

Es wurde wie in Beispiel 4 beschrieben verfahren, jedoch mit dem Unterschied, daß diesmal als Poly(diacetylen) PTS-12 eingesetzt wurde, bei dem in der allgemeinen Formel (II) die Reste $R^1 = R^2$ dem in der Beschreibung unter (c) angeführten Rest entsprechen. Um bei der Wellenlänge von 490 nm eine Änderung der optischen Dichte von 0,17 auf 0,05 zu erreichen, wie es für die Entwicklung des Resistmusters erforderlich war, mußte 60 sec belichtet werden.

Beispiel 11

Es wurde wie in Beispiel 10 beschrieben verfahren, jedoch mit dem Unterschied, daß diesmal zu dem in Chloroform gelösten PTS-12 1 % Anthrachinon hinzugegeben wurde. Die Belichtungszeit konnte auf 20 sec gesenkt werden, um die gleiche Änderung der optischen Dichte zu erreichen, wie in Beispiel 10. Das erhaltene, vorlagengetreue Resistmuster zeigte gute Qualität.

Beispiel 12

Es wurde wie in Beispiel 10 beschrieben verfahren, jedoch mit dem Unterschied, daß der Resistfilm mit einer Strahlung im Wellenlängenbereich oberhalb 495 nm bildmäßig belichtet wurde. Um die optische Dichte der Poly(diacetylen)resistschicht bei der Wellenlänge von 490 nm von 0,17 auf 0,11 abzusenken, mußte 25 min belichtet werden.

Beispiel 13

Es wurde wie in Beispiel 12 beschrieben verfahren, jedoch mit dem Unterschied, daß zu dem in Chloroform gelösten PTS-12 0,12 % Rhodamin 6G hinzugegeben wurden. Um die gleiche Änderung der optischen Dichte wie in Beispiel 12 zu erreichen, mußte mit Licht gleicher Wellenlänge nur 4 min belichtet werden. Es wurde ein Resistmuster entsprechend Beispiel 11 erhalten.

Beispiel 14

Eine Lösung von 1,3 g P3BCMU (Polymer von Beispiel 1) und 1,6.10$^{-2}$ Mol Azobisisobutyronitril in 1 l Chloroform wurde in 4 Teile geteilt. Der eine Teil wurde 10 min, der zweite Teil 20 min, der dritte Teil 30 min und der vierte Teil 40 min bei 45 °C getempert. Die ursprünglich reduzierte Viskosität der Lösung von 1,09 l/g hatte sich im ersten Fall auf 0,72 l/g, im zweiten Fall auf 0,58 l/g, im dritten Fall auf 0,48 l/g und im vierten Fall auf 0,42 l/g verringert. Aus jeder der vier Lösungen wurde jeweils mittels spin-coating ein Film von etwa 10 nm Trockenschichtdicke auf ein aluminiumbedampftes Glassubstrat aufgebracht. Man erhielt auf diese Weise Resistschichten mit differenzierten Eigenschaften.

Beispiel 15

Es wurde wie in Beispiel 4 verfahren, jedoch wurden diesmal zu der Polymer-Lösung noch 1,1.10$^{-3}$ Mol/l Anthrachinon und 2.10$^{-5}$ Mol/l Rhodamin 6G hinzugegeben. Aus dieser Lösung wurde mittels spin-coating auf einem aluminiumbedampften Glassubstrat eine 20 nm dicke Resistschicht hergestellt. Diese wurde durch eine Fotomaske zunächst einmal bildmäßig mit Licht einer Wellenlänge von 546 nm belichtet und entwickelt. Das bildmäßig freigelegte aluminiumbedampfte Glassubstrat wurde geätzt, so daß das Glas bildmäßig freigelegt werden konnte. Die noch nicht belichteten Bereiche des Resists wurden in einem zweiten bildmäßigen Belichtungsschritt durch eine UV-Maske mit ultraviolettem Licht bestrahlt und entwickelt. Nach dieser zweiten bildmäßigen Strukturierung konnte die Aluminiumoberfläche unabhängig vom ersten Ätzschritt erneut behandelt werden.

**Patentansprüche**

1. Trockenfilmresist mit einem dimensionsstabilen, temporären Schichtträger, einer darauf aufgebrachten, festen positiv arbeitenden strahlungsempfindlichen Resistschicht auf Basis eines abbaubaren Polymeren sowie vorzugsweise einer Deckschicht auf der strahlungsempfindlichen Resistschicht, die von der strahlungsempfindlichen Resistschicht ohne gleichzeitiges Entfernen des temporären Schichtträgers abziehbar ist, dadurch gekennzeichnet, daß die strahlungsempfindliche Resistschicht aus einem, insbesondere löslichen, Poly(diacetylen) aufgebaut ist.

2. Trockenfilmresist nach Anspruch 1, dadurch gekennzeichnet, daß die aus den Poly(diacetylenen) aufgebaute strahlungsempfindliche Resistschicht teilkristallin ist.

3. Trockenfilmresist nach einem der Ansprüche 1 oder 2, dadurch gekennzeichnet, daß die Poly(diacetylene) ein mittleres Molekulargewicht (Gewichtsmittel) im Bereich von 10 000 bis 2 000 000, insbesondere im Bereich von 50 000 bis 1 000 000, besitzen.

4. Trockenfilmresist nach einem der Ansprüche 1 bis 3, dadurch gekennzeichnet, daß die Poly(diacetylene) wiederkehrende Einheiten der allgemeinen Formel (II)

$$=\!\!\left[ C(R^{1})-C\equiv C-C(R^{2}) \right]\!\!= \qquad \text{(II)}$$

enthalten, worin bedeuten $R^1$, $R^2$: gleich oder verschieden und unabhängig voneinander einen aliphatischen, aromatischen oder gemischt aliphatisch-aromatischen Rest, insbesondere mit 1 bis 50 C-Atomen, wobei diese Reste gesättigt oder ungesättigt sowie gegebenenfalls substituiert sein können und/oder Heteroatome enthalten und/oder durch Heteroatome oder Heteroatome enthaltende Gruppen unterbrochen sein können.

5. Trockenfilmresist nach Anspruch 4, dadurch gekennzeichnet, daß in den Poly(diacetylenen) der allgemeinen Formel (II) die Reste $R^1$ und $R^2$ Säureester-, Säureamid-, Sulfonat-, Urethan- und/oder Harnstoff-Gruppierungen enthalten.

6. Trockenfilmresist nach einem der Ansprüche 1 bis 5, dadurch gekennzeichnet, daß die strahlungsempfindliche Resistschicht durch aktinische Strahlung aktivierbare Sensibilisatoren enthält, die nach ihrer Aktivierung den Molekülabbau der Poly(diacetylene) zu induzieren oder beschleunigen vermögen.

7. Trockenfilmresist nach Anspruch 6, dadurch gekennzeichnet, daß die strahlungsempfindliche Resistschicht durch aktinisches Licht aktivierbare und/oder durch Wärmestrahlung aktivierbare Sensibilisatoren enthält.

8. Trockenfilmresist nach einem der Ansprüche 1 bis 7, dadurch gekennzeichnet, daß die strahlungsempfindliche Resistschicht einen Weichmacher enthält.

9. Verfahren zur Herstellung von Resistmustern auf einem Substrat, bei dem eine auf das Substrat aufgebrachte, strahlungsempfindliche Resistschicht auf Basis eines abbaubaren Polymeren bildmäßig mit aktinischer Strahlung bestrahlt, hierbei das Polymere abgebaut und dadurch ein selektives Entfernen der bestrahlten Bereiche der Resistschicht ermöglicht wird, danach, gegebenenfalls nach einer Temperung der Resistschicht, die bestrahlten Bereiche der Resistschicht entfernt werden und anschließend das so erhaltene Resistmuster gegebenenfalls nachbehandelt wird, dadurch gekennzeichnet, daß ein Trockenfilmresist gemäß einem der Ansprüche 1 bis 8 eingesetzt wird, dessen strahlungsempfindliche Resistschicht aus einem, insbesondere löslichen, Poly(diacetylen) aufgebaut ist.

10. Verfahren nach Anspruch 9, dadurch gekennzeichnet, daß die aus den Poly(diacetylenen) aufgebaute strahlungsempfindliche Resistschicht 10 nm bis 100 μm dick ist.

11. Verfahren nach einem der Ansprüche 9 bis 10, dadurch gekennzeichnet, daß die bildmäßige Bestrahlung mit aktinischem Licht einer wellenlänge im Bereich von 200 bis 450 nm, insbesondere im Bereich von 250 bis 320 nm erfolgt.

12. Verfahren .nach Anspruch 9 oder 10, dadurch gekennzeichnet, daß die strahlungsempfindliche Resistschicht durch aktinisches Licht aktivierbare Sensibilisatoren enthält und die bildmäßige Bestrahlung mit aktinischem Licht, insbesondere im Wellenlängenbereich von etwa 180 bis 800 nm, vorgenommen wird.

13. Verfahren nach Anspruch 9 oder 10, dadurch gekennzeichnet, daß die strahlungsempfindliche Resistschicht wärmeaktivierbare Sensibilisatoren enthält und die bildmäßige Bestrahlung mit Wärmestrahlung, insbesondere IR-Strahlung einer Wellenlänge größer etwa 0,8 μm, vorgenommen wird.

14. Verfahren nach Anspruch 9 oder 10, dadurch gekennzeichnet, daß die strahlungsempfindliche Resistschicht licht- und wärmeaktivierbare Sensibilisatoren enthält.

15. Verfahren nach einem der Ansprüche 9 bis 14, dadurch gekennzeichnet, daß nach der ersten bildmäßigen Bestrahlung und Entwicklung der Resistschicht die verbleibenden Anteile der Resistschicht mindestens noch einmal bildmäßig bestrahlt und die bestrahlten Bereiche entfernt werden, wobei nach jedem Bestrahlungs- und Entwicklungsvorgang die freigelegten Bereiche des Substrats modifiziert werden können.

16. Verfahren nach einem der Ansprüche 9 bis 15, dadurch gekennzeichnet, daß die strahlungsempfindliche Resistschicht als feste, vorgefertigte Schicht unter Anwendung von Druck sowie gegebenenfalls Wärme auf das Substrat aufgebracht und vor dem Aufbringen kurzzeitig vollflächig vorbestrahlt wird.

**Claims**

1. A dry film resist comprising a dimensionally stable temporary base, a firm positive-working radiation-sensitive resist layer applied thereto and based on a degradable polymer, and preferably on top of the radiation-sensitive resist layer a cover layer which is removable from the radiation-sensitive resist layer by peeling without simultaneous removal of the temporary base, wherein the radiation-sensitive resist layer is composed of one, in particular soluble, poly(diacetylene).

2. A dry film resist as claimed in claim 1, wherein the radiation-sensitive resist layer composed of the poly(diacetylene) is partially crystalline.

3. A dry film resist as claimed in either of claims 1 or 2, wherein the poly(diacetylene) has a weight average molecular weight of from 10,000 to 2,000,000, in particular from 50,000 to 1,000,000.

4. A dry film resist as claimed in any of claims 1 to 3, wherein the poly(diacetylene) contains repeating units of the formula (II)

$$=\!\!\!\![C(R^1)-C\equiv C-C(R^2)]\!\!\!\!= \qquad \text{(II)}$$

where $R^1$ and $R^2$ are identical or different and independently of one another are each an aliphatic, aromatic or mixed aliphatic-aromatic radical of, in particular, 1 to 50 carbon atoms, and these radicals can be saturated or unsaturated and substituted or substituted and/or contain heteroatoms and/or can be interrupted by heteroatoms or groups containing heteroatoms.

5. A dry film resist as claimed in claim 4, wherein, in the poly(diacetylene) of the formula (II), $R^1$ and $R^2$ contain ester, amide, sulfonate, urethane and/or urea groups.

6. A dry film resist as claimed in any of claims 1 to 5, wherein the radiation-sensitive resist layer contains a sensitizer which can be activated by actinic radiation and which, after being activated, is capable of inducing or accelerating molecular degradation of the poly(diacetylene).

7. A dry film resist as claimed in claim 6, wherein the radiation-sensitive resist layer contains sensitizers which can be activated by actinic light and/or sensitizers which can be activated by heat radiation.

8. A dry film resist as claimed in any of claims 1 to 7, wherein the radiation-sensitive resist layer contains a plasticizer.

9. A process for producing a resist pattern on a substrate where a radiation-sensitive resist layer which is based on a degradable polymer and has been applied to the substrate is subjected to imagewise irradiation with actinic radiation, which serves to degrade the polymer and thereby makes possible selective removal of the irradiated areas of the resist layer, thereafter, if desired after a heat treatment of the resist layer, the irradiated areas of the resist layer are removed and then the resist pattern thus obtained is aftertreated if desired, which comprises using a dry film resist as claimed in any of claims 1 to 8 whose radiation-sensitive resist layer is composed of one, in particular soluble, poly(diacetylene).

10. A process as claimed in claim 9, wherein the radiation-sensitive resist layer composed of the poly(diacetylene) is from 10 nm to 100 μm thick.

11. A process as claimed in either of claims 9 or 10, wherein imagewise irradiation is carried out with actinic light having a wavelength of from 200 to 450 nm, in particular from 250 to 320 nm.

12. A process as claimed in claim 9 or 10, wherein the radiation-sensitive resist layer contains a sensitizer which can be activated by actinic light, and imagewise irradiation is carried out using actinic light, in particular that having a wavelength of about 180-800 nm.

13. A process as claimed in claim 9 or 10, wherein the radiation-sensitive resist layer contains a heat-activable sensitizer, and imagewise irradiation is carried out using heat radiation, in particular IR radiation having a wavelength longer than about 0.8 µm.

14. A process as claimed in claim 9 or 10, wherein the radiation-sensitive resist layer contains photoactivable and heat-activable sensitizers.

15. A process as claimed in any of claims 9 to 14, wherein, after the first imagewise irradiation and development of the resist layer, the remaining parts of the resist layer are irradiated imagewise one or more times and the irradiated parts are removed, and the bared parts of the substrate can be modified after each irradiation and development process.

16. A process as claimed in any of claims 9 to 15, wherein the radiation-sensitive resist layer is applied as a firm, prefabricated layer onto the substrate, with the use of pressure and, if required, heat, and is pre-exposed uniformly for a short time before being applied.

**Revendications**

1. Film de réserve à sec, à une couche de support temporaire, stable en dimension, une couche de réserve sensible à l'irradiation travaillant en positif, solide, appliquée sur la couche de support et à base d'un polymère dégradable, et avantageusement une couche de protection sur la couche de réserve sensible à l'irradiation, qui peut être séparée de cette couche de réserve sensible à l'irradiation sans élimination simultanée de la couche de support temporaire, caractérisé par le fait que la couche de réserve sensible à l'irradiation est constituée par une poly(diacétylène), en particulier soluble.

2. Film de réserve à sec selon la revendication 1, caractérisé par le fait que la couche de réserve sensible à l'irradiation constituée par une poly(diacétylène) est partiellement cristalline.

3. Film de réserve à sec selon l'une des revendications 1 ou 2, caractérisé par le fait que les poly(diacétylènes) possèdent un poids moléculaire moyen (moyenne en poids) dans le domaine de 10 000 à 2 000 000, en particulier dans le domaine de 50 000 à 1 000 000.

4. Film de réserve à sec selon l'une des revendications 1 à 3, caractérisé par le fait que les poly(diacétylènes) contiennent des motifs répétitifs de formule générale (II)

$$\text{=}\!\!\!\!\!\![\,C(R^1)-C\equiv C-C(R^2)\,]\!\!\!\!\!\!\text{=} \qquad \text{(II)}$$

$R^1$ et $R^2$, identiques ou différents et indépendants l'un de l'autre, représentant un reste aliphatique, aromatique ou mixte aliphatique-aromatique, en particulier à 1 à 50 atomes C, ces restes pouvant être saturés ou insaturés, et aussi éventuellement substitués et/ou contenir des hétéro-atomes et/ou pouvant être interrompus par des hétéro-atomes ou par des groupes contenant des hétéro-atomes.

5. Film de réserve à sec selon la revendication 4, caractérisé par le fait que, dans les poly(diacétylènes) de formule générale (II), les restes $R^1$ et $R^2$ contiennent des groupements ester, amide, sulfonate, uréthane et/ou urée.

6. Film de réserve à sec selon l'une des revendications 1 à 5, caractérisé par le fait que la couche de réserve sensible à l'irradiation contient des sensibilisateurs activables au rayonnement actiniques et qui, après leur activation, permettent d'induire ou accélérer la dégradation de la molécule de la poly(diacétylène).

7. Film de réserve à sec selon la revendication 6, caractérisé par le fait que la couche de réserve sensible à l'irradiation contient des sensibilisateurs activables à la lumière actinique et/ou activables au rayonnement thermique.

8. Film de réserve à sec selon l'une des revendications 1 à 7, caractérisé par le fait que la couche de réserve sensible à l'irradiation contient un plastifiant.

9. Procédé de réalisation de modèles-réserves sur un substrat, selon lequel on irradie, selon une image, par un rayonnement actinique, une couche de réserve, sensible à l'irradiation, appliquée sur le substrat, et à base d'un polymère dégradable, ce qui dégrade le polymère et permet l'élimination sélective de la zone irradiée de la couche de réserve, puis éventuellement après un traitement thermique de la couche de réserve, on élimine la zone irradiée de la couche de réserve et ensuite on traite encore éventuellement le modèle de réserve ainsi obtenu, caractérisé par le fait que l'on met en œuvre un film de réserve à sec, selon l'une des revendications 1 à 8, dont la couche de réserve sensible à l'irradiation est constituée d'une poly(diacétylène), en particulier soluble.

10. Procédé selon la revendication 9, caractérisé par le fait que la couche de réserve sensible à l'irradiation constituée de la poly(diacétylène) est d'une épaisseur de 10 nm à 100 µm.

11. Procédé selon l'une des revendications 9 à 10, caractérisé par le fait que l'irradiation, selon une image, a lieu avec une lumière actinique d'une longueur d'onde comprise entre 200 et 450 nm, en particulier comprise entre 250 et 320 nm.

12. Procédé selon la revendication 9 ou 10, caractérisé par le fait que la couche de réserve sensible à l'irradiation, activable par la lumière actinique, contient des sensibilisateurs et l'irradiation, selon une image, est effectuée à la lumière actinique, en particulier dans une zone de longueurs d'onde d'environ 180 à 800 nm.

13. Procédé selon la revendication 9 ou 10, caractérisé par le fait que la couche de réserve sensible à l'irradiation contient des sensibilisateurs activables à la chaleur et l'irradiation, selon une image, est effectuée avec un rayonnement thermique, en particulier un rayonnement IR d'une longueur d'onde supérieure à environ 0,8 µm.

14. Procédé selon la revendication 9 ou 10, caractérisé par le fait que la couche de réserve sensible à l'irradiation contient des sensibilisateurs activables à la lumière et à la chaleur.

15. Procédé selon l'une des revendications 9 à 14, caractérisé par le fait qu'après la première irradiation, selon une image, et développement de la couche de réserve, la portion restante de la couche de réserve est irradiée, selon une image, au moins encore une fois et les zones irradiées sont éliminées, les zones du substrat laissées libres après chaque irradiation et développement pouvant être modifiées.

16. Procédé selon l'une des revendications 9 à 15, caractérisé par le fait que la couche de réserve sensible à l'irradiation est appliquée par le substrat sous forme de couche solide, préfabriquée, en utilisant la pression et éventuellement aussi la chaleur, et elle est pré-irradiée, sur toute sa surface, temporairement avant l'application.